# EUROPÄISCHE PATENTSCHRIFT

(11) **EP 4 010 966 B1**
(45) Veröffentlichungstag und Bekanntmachung des Hinweises auf die Patenterteilung: **10.07.2024**
(21) Anmeldenummer: 20804473.5
(22) Anmeldetag: 04.11.2020
(51) Int. Cl.: H02K 11/33, H02K 9/06

(54) **ANTRIEB MIT SEGMENTIERTEM UMRICHTERGEHÄUSE**
DRIVE WITH SEGMENTED CONVERTER HOUSING
ENTRAÎNEMENT POURVU DE BOÎTIER DE CONVERTISSEUR SEGMENTÉ

(30) Priorität: 22.11.2019 EP 19210995
(43) Veröffentlichungstag der Anmeldung: 15.06.2022
(73) Patentinhaber: Innomotics GmbH, 90441 Nürnberg (DE)
(72) Erfinder: DEEG, Christian, 90518 Altdorf (DE); KUHN, Harald, 90482 Nürnberg (DE); LEHNER, Johannes, 90762 Fürth (DE); MAIDORN, Mischa, 90547 Stein (DE); TISCHMACHER, Hans, 91207 Lauf (DE); TSOTOULIDIS, Savvas, 90491 Nürnberg (DE)
(74) Vertreter: Siemens Patent Attorneys
(86) Internationale Anmeldenummer: PCT/EP2020/080958
(87) Internationale Veröffentlichungsnummer: WO 2021/099121

(56) Entgegenhaltungen:
- EP-A1- 0 557 883
- EP-A1- 1 271 749
- EP-A1- 2 348 799
- WO-A1-2016/188756
- JP-A- H10 248 198
- US-A1- 2018 177 080

## Beschreibung

Die Erfindung betrifft ein elektronisches Anbauteil, eine Antriebseinheit mit einer dynamoelektrischen Maschine und zumindest einem elektronischen Anbauteil als auch die Herstellung des elektronischen Anbauteils.

Ein antriebstechnisches System mit variablen Drehzahlen besteht aus einem Motor und einem Umrichter, die eine gemeinsame Einheit bilden.

Derartige Antriebseinheiten sind beispielsweise aus der DE 198 12 729 A1 bekannt. Dort wird ein Elektromotor, insbesondere mit einem Lüfterrad zur Bildung eines Axial- oder Radiallüfters beschrieben, mit einer Antriebseinheit und einer ein Steuerungsgehäuse aufweisenden Steuereinheit, wobei die Antriebseinheit einen Stator, ein Läufer und zumindest eine elektrische Spule aufweist und wobei die Steuereinheit eine elektronische Schaltung zur Steuerung oder Regelung der Stromzufuhr zur Spule aufweist. Die Antriebseinheit und die Steuereinheit sind durch Module gebildet und einander zugeordnete Kontaktelemente sind zur gegenseitigen elektrischen Verbindung vorgesehen.

Ebenso ist eine Antriebseinheit aus der DE 38 42 588 A1 bekannt. Dort wird ein kollektorloser Gleichstrom-Außenläufermotor beschrieben, der aus einem an einem Motorflansch befestigten Stator mit Statorwicklungen, einem den Stator auf seiner dem Motorflansch abgekehrten Seite umschließenden Außenläufer sowie einer elektronischen, die Statorwicklungen ansteuernden Schaltungsanordnung besteht. Diese Schaltungsanordnung besitzt eine flanschseitig dem Stator zugekehrten angeordnete, elektronischen Bauelemente tragende Leiterplatte sowie mehrere an der Leiterplatte elektrisch angeschlossene, in wärmeleitendem Kontakt mit dem Motorflansch angeordnete Leistungshalbleiter. Die Leistungshalbleiter sind mittelbar über einen ringscheibenförmigen Kühlkörper mit dem Motorflansch wärmeleitend verbunden. Der Kühlkörper bildet mit der Leiterplatte und einem die Leiterplatte halternden Trägerelement eine vormontierte Baugruppe.

Die Herstellung dieser antriebstechnischen Systeme bestehend aus einem Motor und einem Umrichter beinhaltet unter anderem die Bestückung einer Leiterplatte mit Leistungselektronik, sowie deren Platzierung als auch der Platzierung weiterer Leistungselektronik in einem Aluminium-Gussgehäuse. Die Platine bietet nicht ausreichend Bauraum, um die komplette Leistungselektronik darauf zu montieren. Deswegen muss teilweise die Leistungselektronik an der Innenseite des Gussgehäuses montiert werden.

Das Gussgehäuse fungiert unter anderem als Kühlkörper. Um eine gute Wärmeabfuhr vom Gussgehäuse zu gewährleisten ist eine entsprechende Ebenheit, Oberflächenrauheit und Wärmeanbindung zur jeweiligen Leistungselektronik vorzusehen. Bedingt durch den Druckgussprozess sind hier jedoch zur Sicherstellung der geforderten Maße, Formtoleranzen und Oberflächenrauheiten Nachbearbeitungen erforderlich, da diese durch Lunker oder Schwindung beim Erkalten nicht garantiert werden können. Des Weiteren werden viele Gewindebohrungen zur Befestigung der Abdeckungen, der Platine, der Kabeleinführung und der Leistungselektronik benötigt. Einige dieser Gewindebohrungen führen zu einer vergleichsweise aufwendigen Bearbeitung, da sich diese auf der Innenseite des Gussgehäuses befinden und somit eine Hinterschneidung bilden.

Dies führt auch zu einer komplexen und unübersichtlichen Leitungsverlegung innerhalb des Gussgehäuses, was auch einen hohen manuellen Aufwand unter stark beengten Platzverhältnissen zur Folge hat.

Aus der US 2018-177080 A1 ist eine elektrische Energieumwandlungsvorrichtung mit einer Rahmeneinheit bekannt, die durch einen röhrenförmigen Außenrahmen und einen röhrenförmigen Innenrahmen konfiguriert ist, der in dem Außenrahmen in einem montierten Zustand gehalten wird. Dabei sind Leistungsmodule innerhalb der Rahmeneinheit untergebracht, die an Seitenwandflächen des Innenrahmens montiert sind, die radial nach innen weisen. Dabei umfasst der innere Rahmen eine Vielzahl von Basiselementen und Verbindungsabschnitten, die die Basiselemente nacheinander verbinden, wobei die Basiselemente in einer röhrenförmigen Form in einem Zustand konfiguriert sind, dass Basiselemente, die an zwei Enden in einer Verbindungsrichtung positioniert sind, aneinanderstoßen.

Eine automatisierte Fertigung und automatisierte Prüfung insbesondere der Leistungskomponenten ist so nahezu unmöglich. Ausgehend davon liegt der Erfindung die Aufgabe zugrunde, ein kompaktes elektronisches Anbauteil und eine kompakte Antriebseinheit zu schaffen, die eine ausreichende Kühlung der Antriebseinheit gewährleistet und aufwandsarm herstellbar ist.

Die Lösung der gestellten Aufgabe gelingt durch Herstellung eines Umrichters eines Antriebs mit Steller- und/oder Umrichterkomponenten durch die im unabhängigen Anspruch 1 definierten Schritte.

Diese Fertigungsschritte können dabei zumindest teilweise nacheinander und/oder auch gleichzeitig erfolgen.

Die Lösung gelingt auch durch einen Umrichter eines Antriebs mit Steller- oder Umrichterkomponenten gemäß Anspruch 5.

Die Lösung der gestellten Aufgabe gelingt auch durch einen Antrieb gemäß Anspruch 8.

Die gesamte erfindungsgemäße Platine setzt sich aus mehreren zusammenhängenden Teilplatinen zusammen, nämlich einer Zentralplatine und deren Randplatinen. Die Randplatinen sind über eine biegsame, elektrisch leitende Konstruktion, insbesondere Starrflex-Verbindungen mit der Zentralplatine verbunden. Diese Verbindungen können nach der Bestückung der Zentral- wie auch der einzelnen Randplatinen um einen definierten Winkel an den vorgegebenen Stellen gebogen geknickt werden. Dieser Biege-Vorgang kann auch ohne Werkzeuge vorgenommen werden.

Somit kann die komplette Leistungselektronik in einem Bestückungsvorgang auf den einzelnen Platinen montiert werden. Es ist somit keine weitere Leistungselektronik manuell in einem Gehäuse zu montieren. Durch die Verwendung der Starrflexverbindung kann der verfügbare Bauraum im Gehäuse optimal genutzt werden.

Die Gehäuseanordnung des elektronischen Anbauteils wird erfindungsgemäß nicht mehr als Gussgehäuse ausgeführt. Sie wird in mehrere, vorzugsweise gleichartige Segmente aufgeteilt, welche mittels Strangpressverfahren hergestellt werden können.

Die Segmente sind aus vergleichsweise thermisch gut leitfähigem Material, wie Aluminium oder einer Aluminiumlegierung. Hierdurch entsteht ein Kostenvorteil aufgrund des Entfalls der teuren Druckgussform im Gegensatz zum Strangpresswerkzeug.

Die Maßhaltigkeit, die Ebenheit und die Oberflächenrauheit des Strangpressprofils erfordern im Gegensatz zu einem Gußgehäuse keine weitere Bearbeitung. Des Weiteren ist die Herstellung der Befestigungsbohrungen für die Randplatinen einfacher zu realisieren, da in diesem Design keine Hinterschneidung vorhanden ist. Die Bohrungen zur Befestigung eines Deckels werden in das Strangpresswerkzeug integriert und müssen somit nicht mehr gebohrt werden. Das Strangpressprofil weist zusätzlich eine bessere Wärmeleitfähigkeit im Gegensatz zum Druckgussgehäuse auf, da dieses ein gleichmäßigeres und lunkerfreies Gefüge aufweist.

Der Automatisierungsgrad zur Herstellung des elektronischen Anbauteils und damit des Antriebs wird damit deutlich erhöht. Die Bestückung der Gesamtplatine, die sich aus der Zentralplatine und den Randplatinen mit der jeweiligen Leistungselektronik zusammensetzt, kann vollautomatisiert erfolgen. Auch die anschließende Prüfung der Gesamtplatine kann vollautomatisiert erfolgen, da dies vorteilhafterweise in einer Ebene erfolgt.

Unter Leistungselektronik des Stellers und/oder Umrichtern, und unter elektrischen und elektronischen Bauelementen in dem elektronischen Anbauteil wird dabei die für einen Antrieb bzw. dynamoelektrische Maschine notwendig Elektronik verstanden, die eine oder mehrere der beispielhaft aufgeführten Komponenten aufweisen kann. Treiberelektronik mit Stromversorgung, Überwachungsmodule für Spannung, Strom oder thermischer Zustand, Leistungshalbleiter (IGBT, Triacs, Thyristoren etc.), integrierte Schutzfunktionen (Überstrom, Unterspannung, Kurzschluss etc.), Bremschopper etc.

Die Kontaktierung dieser auf den Platinen vorgesehene Leistungselektronik erfolgt beispielsweise über eine Steckverbindung, Lötverbindungen etc. Diese Leistungselektronik wird vor, nach oder während der Kontaktierung mit der Randplatine fest mit dem oder den dazugehörigen Segmenten verbunden. Diese Verbindung ist thermisch gut leitend, was durch Auswahl der Materialien, als auch durch ev. Wärmeleitpasten unterstützt wird.

Durch eine Biegung bzw. Knickung der Randplatinen bzgl. der Zentralplatine, vorzugsweise um 90°, können nun die einzelnen Segmente mittels Konnektoren verbunden werden. Es wird somit eine geschlossene Umfangsfläche - die Abdeckung geschaffen.

An der Innenseite der Abdeckung befinden sich die Randplatinen, die im Wesentlichen tangential angeordnet sind. Zumindest eine Seite der Randplatinen ist mit der Zentralplatine elektrisch verbunden. Die Zentralplatine ist im Wesentlichen senkrecht zu einer Achse des Antriebs angeordnet.

In Verbindung mit einem oberen und unteren Deckel und der Abdeckung wird eine geschlossene Gehäuseanordnung des elektronischen Anbauteils geschaffen. Es ist aufgrund der elektrisch leitenden Verbindung zwischen der Zentralplatine und den Randplatinen keine weitere Leitungsverlegung im Inneren der Gehäuseanordnung erforderlich.

Durch die Verwendung von Zentral- und Randplatine kann die komplette Leistungselektronik automatisiert auf die jeweiligen Platinen bestückt und geprüft werden. Dies führt zu einer höheren Produktivität und einer deutlichen Reduktion der Montagekosten.

An der Abdeckung, als auch an den Segmenten sind keine weitere Bearbeitungsschritte erforderlich, um die erforderliche Maßhaltigkeit, Ebenheit und Oberflächenrauheit zu erreichen, da diese mittels Strangpressverfahren erzeugt werden können.

Die Abdeckung bzw. die Segmente sind aus vergleichsweise thermisch gut leitfähigem Material, wie Aluminium oder einer Aluminiumlegierung.

Hierdurch wird eine einfachere und kostengünstigere Herstellung u.a. der thermischen Anbindung der Leistungselektronik an das Segment umgesetzt. Lediglich die Gewindebohrungen zur Befestigung der Leistungselektronik und der Kabelführung müssen noch erzeugt werden. Die Bohrungen zur Befestigung der Abdeckungen sind bereits in das Strangpressprofil integriert.

Des Weiteren weist jedes einzelne Segment bessere Kühleigenschaften durch die Verwendung des Strangpressherstellprozesses im Gegensatz zu einem Druckgussprozess auf. Außerdem kann die teure Druckgussform durch ein wesentlich günstigeres Strangpresswerkzeug ersetzt werden.

Damit ergibt sich ein sehr kompakter und leistungsfähiger Antrieb, dessen Komponenten, insbesondere das elektronische Anbauteil als auch die dynamoelektrische rotatorische Maschine ausreichend kühlbar sind.

Über die Abdeckung des elektronischen Anbauteils werden dessen Elemente, wie Leistungshalbleiter, Steuer- und Regeleinheiten gekühlt. Bei der dynamoelektrischen rotatorischen Maschine, werden insbesondere über eine Welle und den an einem Gehäuse der dynamoelektrischen rotatorischen Maschine entlang geführten Kühlluftstrom Stator und Rotor gekühlt.

Die gesamte durch Segmente gebildete Abdeckung ist im Wesentlichen rohrförmig ausgestaltet. Durch beidseitig anzubringende Deckel wird das Gehäuse der elektronischen Anbauteils geschaffen. Je nach Antriebssystem weisen die Deckel zentrale Öffnungen auf - ebenso wie die Zentralplatine. Diese axialen Öffnungen werden durch einen Tubus zur Welle hin berührungsfrei abgedichtet. Durch diese Öffnungen ragt nunmehr berührungsfrei die Welle, die u.a. die Antriebswelle der Kühleinheit, insbesondere eines Lüfters ist. Damit ist nun beispielsweise eine geeignete Eigenbelüftung des Antriebs möglich.

Die Abdeckung bzw. die Segmente weisen an ihrer Außenseite axial verlaufende und radial erstreckende Rippen auf. Die Innenseite der Segmente ist vorzugsweise eben ausgeführt, um Steller- oder Umrichterkomponenten direkt an der Innenseite des Segments thermisch gut anzubinden.

Der Rotor einer dynamoelektrischen Maschine wird u.a. auch über die Welle gekühlt. Außerdem wird Wärme des Rotors auch an den Innenraum der dynamoelektrischen rotatorischen Maschine abgegeben, so dass sich die Lagerschilde, Lager und Gehäuse dadurch ebenfalls erwärmen können. Dieser Wärmeeintrag wird durch die das Gehäuse und die Lagerschilde umströmende Luft, insbesondere durch die adaptierbare Kühleinheit, z.B. den Lüfter abgeführt.

Der Stator erzeugt ebenso Wärme, die u.a. den Innenraum der dynamoelektrischen rotatorischen Maschine aufheizt. Dieser Wärmeeintrag wird ebenfalls durch die das Gehäuse und die Lagerschilde umströmende Luft abgeführt. Des Weiteren ist der Stator vorzugsweise in einen Mantel des Gehäuses eingeschrumpft, um einen vergleichsweise guten Wärmeübergang vom Blechpaket des Stators auf das Gehäuse und die Gehäuserippen zu erhalten.

Die insbesondere als Eigenlüfter ausgeführte Kühleinheit generiert im Betrieb der dynamoelektrischen rotatorischen Maschine einen Kühlluftstrom, der zunächst radial entlang dem Gehäuse des elektronischen Anbauteils geführt ist. Eine Lüfterhaube, die sich axial Richtung AS-Lager erstreckt, führt den Kühlluftstrom auch entlang der Kühlrippen von Abdeckung und Gehäuse der dynamoelektrischen rotatorischen Maschine.

Die Erfindung sowie weitere vorteilhafte Ausgestaltungen der Erfindung werden anhand prinzipieller dargestellter Ausführungsbeispiele näher dargestellt; darin zeigen:
- FIG 1: einen prinzipiellen Längsschnitt eines erfindungsgemäßen Antriebs,
- FIG 2: Gesamtplatine mit Zentral- und Randplatinen,
- FIG 3: Platinenanordnung mit Segmenten,
- FIG 4: elektronisches Anbauteil,
- FIG 5: perspektivische Darstellung eines Antriebs.

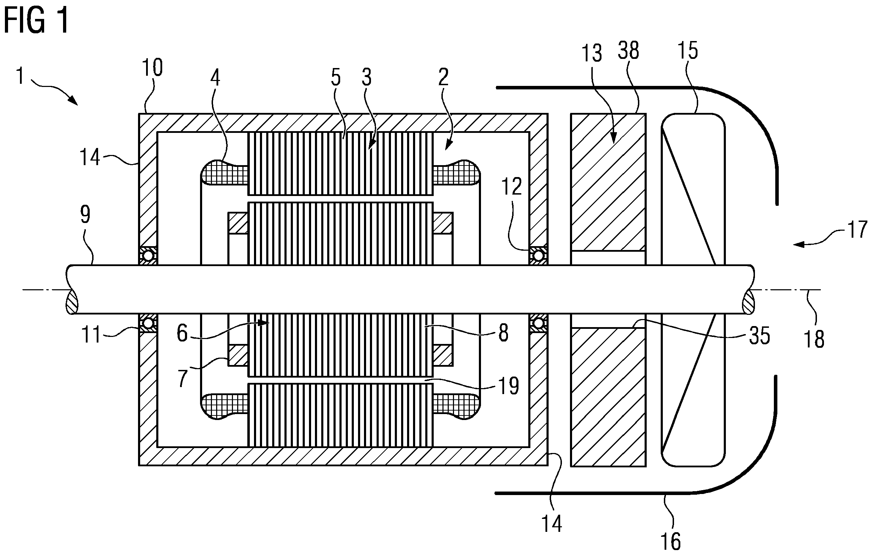

FIG 1 zeigt in einem prinzipiellen Längsschnitt einen Antrieb 1 mit einer dynamoelektrischen rotatorischen Maschine 2, die einen Stator 3 mit einem Blechpaket 5 aufweist. In dem Blechpaket 5 des Stators 3 ist, einem Luftspalt 19 zugewandt, ein Wicklungssystem angeordnet, das an den Stirnseiten des Blechpakets 5 des Stators 3 Wickelköpfe 4 ausbildet. Drehfest mit einer Welle 9 ist ein Blechpaket 8 eines Rotors 6 verbunden, das in elektromagnetischer Wechselwirkung mit einem bestromten Wicklungssystem des Stators 3 steht und so zu einer Rotation der Welle 9 um eine Achse 18 führt. Die Welle 9 ist in zwei Lagern gehalten, einem AS-Lager 11 und einem BS-Lager 12.

Die dynamoelektrische rotatorische Maschine 2 ist von einem Gehäuse 10 umgeben, das an den Stirnseiten von Lagerschilden 14 begrenzt ist. Axial von der BS-Lager-Seite beabstandet befindet sich ein elektronisches Anbauteil 13, das zumindest Elemente eines Umrichters und/oder Stellers beinhaltet. Das elektronische Anbauteil 13 ist ortsfest und nicht mit der Welle drehfest verbunden. Axial daran schließt sich ein Lüfter 15 an, der wiederum drehfest mit der Welle 9 verbunden ist und einen Kühlluftstrom generiert, der durch eine Lüfterhaube 16 geführt wird. Der Luftstrom wird über eine Ansaugöffnung 17 dem Lüfter 15 zugeführt.

Bei dem Antrieb 1, insbesondere zwischen dem elektronischen Anbauteil 13 und dem zugewandten Lagerschild 14 tritt im Betrieb des Antriebs 1 ein Wärmestau ein. Der Wärmeeintrag erfolgt dabei von beiden axialen Seiten. So führt Verlustwärme aus dem Umrichter und/oder Steller, also dem elektronischen Anbauteil 13, als auch Wärme aus der Maschine 2 über das Lagerschild zu diesem Wärmestau zwischen den einzelnen Komponenten. Die Wärme aus der Maschine 2 setzt sich u.a. aus der Verlustwärme von Stator 3 und Rotor 6 zusammen. Diese heizen zusätzlich die benachbarten Lager 11, 12 auf, was den Schmierstoff der Lager beeinträchtigt und kürzere Nachschmierfristen erfordern würde.

Die Wärme wird auch über die Welle 9, insbesondere aus dem Rotor 6 der dynamoelektrischen rotatorischen Maschine 2 transportiert und dem Lüfter 15 zugeführt, der u.a. als Wärmeabgabeelement fungiert. Der Lüfter 15 erzeugt im Betrieb der dynamoelektrischen rotatorischen Maschine 2 auch einen Kühlluftstrom.

Das elektronische Anbauteil 13 ist von der Welle 9 beabstandet und ortsfest und über mechanische Verbindungen am benachbarten Lagerschild und /oder an einer Lüfterhaube 16 fixiert.

Elektrische Verbindungen und/oder Datenleitungen zwischen dem elektronischen Anbauteil 13 und der dynamoelektrischen Maschine 2 sind über den Deckel 36 und einen Durchbruch im gegenüberliegenden Lagerschild 14 möglich.

Ebenso ist es möglich Leitungen über ein Anschlusselement 32 in einen Klemmenkasten 37 der dynamoelektrischen Maschine 2 zu führen.

Diese Verbindungen erfolgen alle unter Einhaltung der jeweiligen vorgegebenen Schutzart über das Lagerschild 14 und/oder das Gehäuse 10 und/oder einen Klemmkasten 37 am Gehäuse 10.

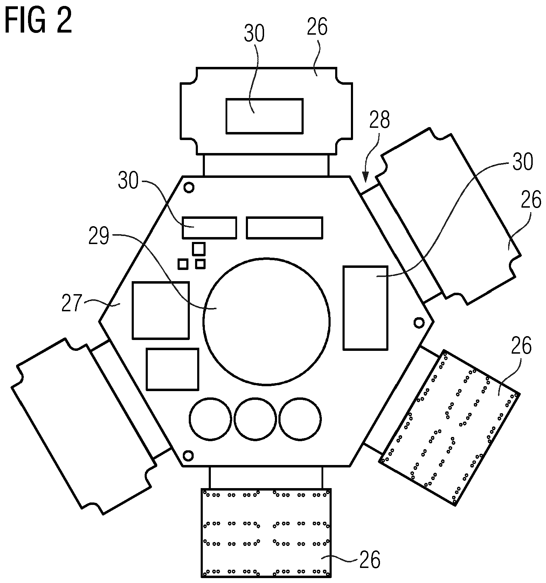

FIG 2 zeigt eine bespielhafte Anordnung einer Gesamtplatine mit Zentralplatine 27 und Randplatinen 26 in einer Ebene. Auf der Zentralplatine 27 sind einige Leistungsmodule angeordnet, die über Starrflex-Verbindungen in den Biegeabschnitten 28 mit den auf den Randplatinen 26 angeordneten Leistungsmodulen elektrisch kontaktiert sind. Die Zentralplatine 27 weist in diesem Beispiel eine sechseckige Grundform auf, wobei eine Seite frei von der Randplatine 26 ist, um dort Anschlussmöglichkeiten beispielsweise zu einem Motor und/oder Klemmkasten 37 zu ermöglichen. Es sind auch andere Grundformen der Zentralplatine 27, wie drei-, vier-, acht- oder zwölf-eckig möglich.

Die Biegelinien der Biegeabschnitte 28 verlaufen parallel zu der jeweiligen Außenkante der gewählten Grundform.

Es sind selbstverständlich auch schräg verlaufende Biegelinie vorstellbar, dies hängt u.a. von der gewählten Grundform und deren Winkel ab.

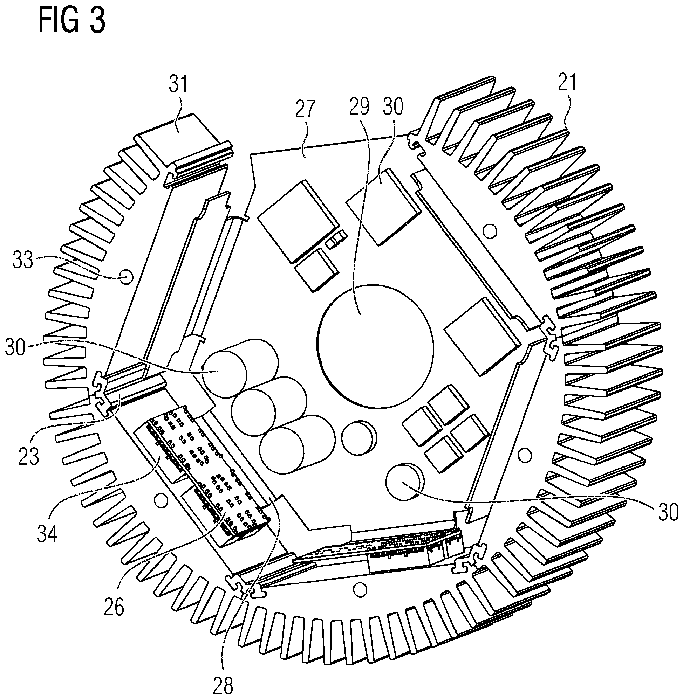

FIG 3 zeigt die abgebogenen Randplatinen 26 und deren thermische Kontaktierung mit den jeweiligen Segmenten 31. Dabei sind die Randplatinen 26 bzgl. der Zentralplatine 27 an dem Biegeabschnitt 28 unter einem vorgegebenen Winkel, insbesondere 90 Grad abgebogen angeordnet.

Die Randplatinen 26 mit ihren sind thermisch möglichst direkt an die Segmente 31 angebunden.

Von der Randplatine 26 besteht also eine thermisch leitende Verbindung 34 zumindest zu ihrem jeweiligen Segment 31. Die Segmente 31 weisen Bohrungen 33 auf, um - in dieser Darstellung noch nicht gezeigte - Deckel 36 anzubringen. Die einzelnen Segmente 31 werden miteinander mechanisch durch Konnektoren 23 (Verbindungselemente wie Schrauben, Schnappverbindungen, etc.) verbunden und bilden so eine umfänglich geschlossene Abdeckung 20. Die Konnektoren stellen außer einer mechanischen Fixierung optional auch eine thermisch leitfähige Verbindung dar, um über die Abdeckung 20 eine Vergleichmäßigung der Temperatur des elektronischen Anbauteils 13 zu erreichen.

Die Abdeckung 20 und somit auch die Segmente 31 sind aus thermisch gut leitfähigem Material, so dass die Verlustwärme der Steller- und/oder Umrichterkomponenten aus dem elektronischen Anbauteil 13 verursacht u.a. durch die Bauelemente 30 und/oder die Leistungsmodule, an den Kühlluftstrom abgebbar ist. Zusätzliche Rippen 21 an den Segmenten 31 erhöhen den Wärmeabgabeeffekt, insbesondere dann, wenn wie in FIG 1 dargestellt, eine Lüfterhaube 16 den Kühlluftstrom leitet.

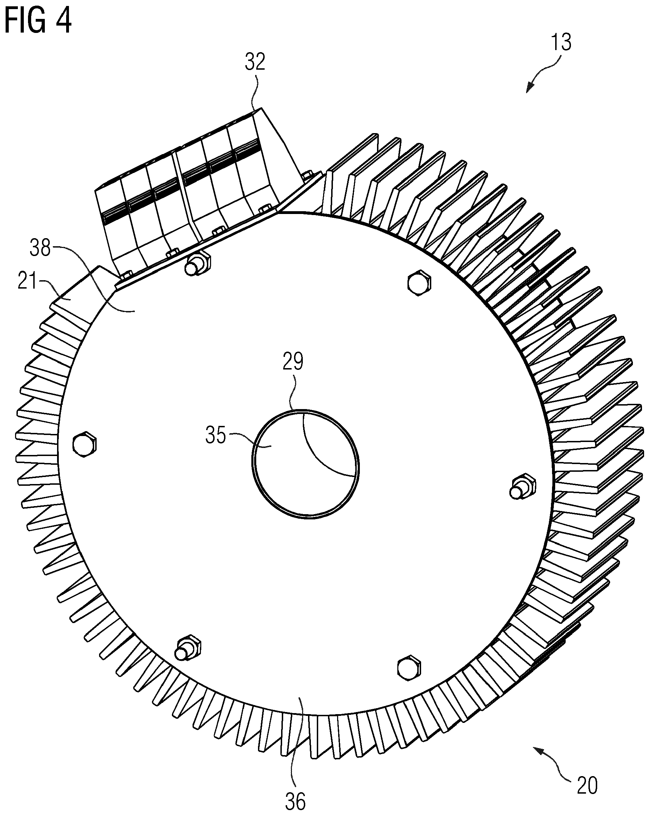

FIG 4 zeigt ein abgeschlossenes elektronisches Anbauteil 13, dessen Gehäuseanordnung 38 aus einer im wesentlichen zylindrischen Abdeckung 20, und zwei Deckeln 36 gebildet wird. Zwischen den Deckeln 36 ist im Bereich der Öffnung 29 der Zentralplatine 27 ein Tubus 35 vorhanden, um der Welle einen Durchgriff zu gestatten. Damit lässt sich eine Eigenbelüftung des Antriebs 1 ermöglichen, da die Welle 9 einen Lüfter 15 direkt antreiben kann. Die Welle 9 hat keinen Kontakt mit dem Tubus 35, um u.a. eine Wärmeübertrag in das elektronische Anbauteil 13 zu verhindern.

Es kann stattdessen oder zusätzlich auch ein Fremdlüfter vorgesehen sein.

Im Bereich der "fehlenden" Randplatine 26 ist ein Anschlusselement 32 vorgesehen, um eine elektrische Versorgung des Antriebs 1 zu gewährleisten. Falls alle Seiten der Zentralplatine 27 mit Randplatinen 26 versehen sind, kann eine elektrische Versorgung auch über einen Deckel 36 erfolgen.

Vorteilhafterweise sind die Rippen 21 und die Rippen des Gehäuses 10 der dynamoelektrischen rotatorischen Maschine 2 in axialer Flucht, um somit dem Kühlluftstrom möglichst wenig Strömungswiderstand entgegenzusetzen.

Durch die Abdeckung 20 und durch dementsprechende Ausgestaltung der Deckel 36 kann das elektronische Anbauteil 13 auch höhere Schutzarten einhalten.

Des Weiteren dient die Abdeckung 20 auch als Wärmepuffer für schwankende Betriebszustände des Antriebs 1, z.B. kurzzeitige Überlast.

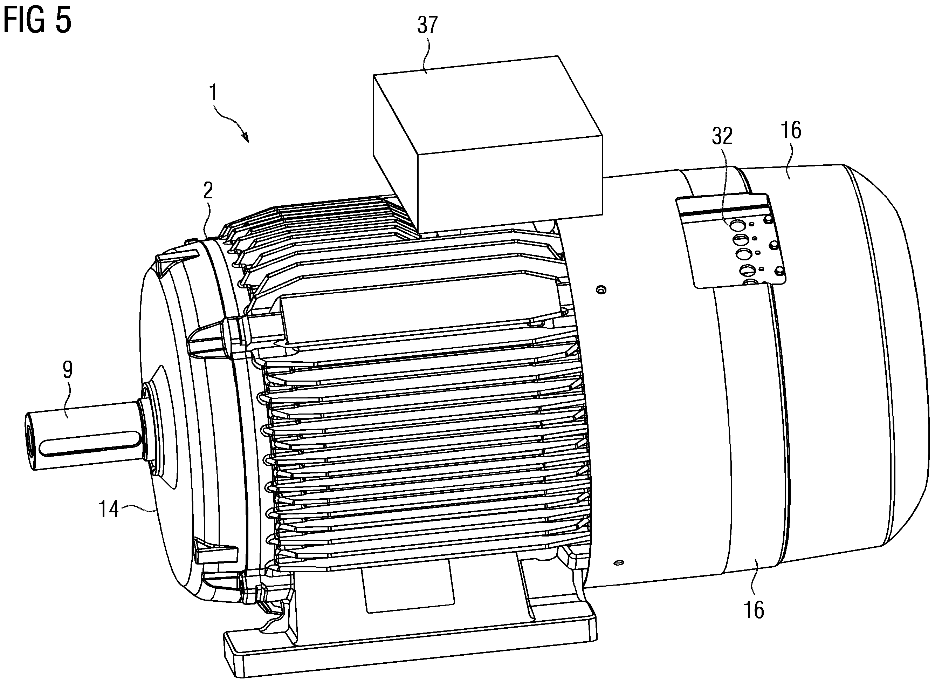

Nach FIG 5, die einen vereinfacht dargestellten Antrieb 1 zeigt, kann die Lüfterhaube 16 auch einen Durchgriff 22 zur Kontaktierung an das elektronische Anbauteil 13 aufweisen. Des Weiteren kann die Lüfterhaube 16 axial auch in zwei Teile unterteilt sein, um Servicearbeiten an Lüfter 15 und/oder elektronischem Anbauteil 13 zu erleichtern.

Der Antrieb 1 bzw. die Antriebseinheit ist grundsätzlich kompakt aufgebaut. Dabei können die vorab beschriebenen und die folgenden Merkmale einzeln oder in beliebiger Kombination zur Gestaltung des Antriebs 1 angezogen und zusammengestellt werden. Dabei soll der kompakte Antrieb 1 u.a. bestmöglich gekühlt werden.

Dazu wird an die dynamoelektrische rotatorische Maschine 2 axial zumindest ein elektronisches Anbauteil 13 oder Komponenten davon, wie ein oder mehrere Leistungshalbleiter, Drosseln, Kondensatoren und Regelungsbausteine, vorgesehen. Diese Komponenten des elektronischen Anbauteils 13 sind in einer geschlossenen Gehäuseanordnung des elektronisches Anbauteil 13 angeordnet, die abschnittsweise von der Abdeckung 20 gebildet wird.

Eine Kühlung des Antriebs 1 und seiner jeweiligen Abschnitte/Teile/Komponenten erfolgt durch eine oder mehrere Kühleinheiten, die als Flüssigkeitskühlung (Kühlmantel an Gehäuseanordnung 38 und/oder am Gehäuse 10 der dynamoelektrischen rotatorischen Maschine 2 realisiert werden kann. Vorzugsweise wird eine Luftkühlung vorgesehen, deren Lüfter 15 an der der dynamoelektrischen rotatorischen Maschine 2 abgewandten Seite der Gehäuseanordnung liegt, so dass eine axiale Reihenfolge von Lüfter 15, Gehäuseanordnung des elektronischen Anbauteils 13 und dynamoelektrischer rotatorischer Maschine 2 vorliegt.

Der Lüfter 15 kann auch als eine Lüftereinheit aus einem oder mehreren Eigen- und/oder auch Fremdlüftern aufgebaut sein, die auch zumindest teilweise an oder in einer Lüfterhaube 16 integriert sein können.

Zur Verbesserung des Kühleffekts sind oberflächenvergrößernde Maßnahmen an der Gehäuseanordnung 38 und/oder dem Gehäuse 10 der dynamoelektrischen rotatorischen Maschine 2 vorgesehen. Dabei sind dort Rippen 21, Noppen oder zusätzliche Wärmekapazitäten in Form von Gehäuseerweiterung vorgesehen, die Wärmelasten bei dementsprechendem Betrieb des Antriebs 1 puffern können.

Außerdem wird durch spezielle Gestaltung bzw. Aussparungen zwischen dynamoelektrischer rotatorischer Maschine 2, insbesondere deren Lagerschild 14 und der Gehäuseanordnung 38 Kühlkanäle geschaffen, die durch dementsprechende Gestaltung und einem Hauptluftstrom einen zur Kühlung betragenden Venturieffekt in den Aussparungen erzielen.

Die Gehäuseanordnung 38 kann dabei auch trichterförmig ausgebildet, wobei der Trichter einen zylindrischen Abschnitt und einen axial verjüngenden Abschnitt aufweist, die einstückig aus gleichem Material, aus mehreren Teilen mit unterschiedlichen Materialien und aus mehreren Teilen mit gleichem Material ausgeführt sein können. Die Abdeckung 20 bildet dabei dann einen Teil des Trichters, der sich in Richtung Lüfter 15 verjüngt.

Um die Oberfläche der Gehäuseanordnung 38, insbesondere der Abdeckung 20 zu vergrößern weist der zylindrische Abschnitt und/oder der sich axial verjüngenden Abschnitt an seiner Außenseite axial bzw. quasi-radial erstreckende Rippen auf.

Um einen trichterförmigen Aufbau der Abdeckung 20 zu erhalten sind zwischen Randplatine 26 und Zentralplatine 27 ggf. andere Biegewinkel vorzusehen.

Die Innenseite des zylindrischen Abschnitts und/oder des sich axial verjüngenden Abschnitt ist polygonal ausgeführt, um Steller- und/oder Umrichterkomponenten direkt an der Innenseite der Gehäuseanordnung 38 anordnen zu können. Damit wird eine vergleichsweise thermisch gute Anbindung gewährleistet.

Die Steller- oder Umrichterkomponenten können insbesondere auch ausschließlich im zylindrischen Abschnitt angeordnet sein, in diesem Fall wirkt der sich axial verjüngenden Abschnitt als Wärmekapazität, der eine thermisch puffernde Wirkung aufweist. Dieser Abschnitt ist dann als Vollmaterial ausgeführt, der gleichzeitig für den Lüfter 15 die Funktion einer Deckscheibe erfüllt. Damit können axial kürzere Lüfter 15 eingesetzt werden, um so eine kompaktere Bauweise des Antriebs zu erhalten.

Ebenso ist es möglich im elektronischen Anbauteil 13 eine oder mehrere Innenlüfter vorzusehen, die innerhalb des geschlossenen elektronischen Anbauteils 13 zu einem Innenkühlkreislauf führen. Der Innenlüfter ist dabei entweder separat als Fremdlüfter temperaturabhängig ansteuerbar, oder magnetisch mit der Welle 9 gekoppelt, so dass eine Art Eigenbelüftung des elektronischen Anbauteils 13 vorliegt, sobald sich die Welle 9 dreht.

Der Antrieb des Innenlüfters erfolgt über eine magnetische Kopplung von auf der Welle 9 positionierten Magneten und dementsprechend angeordneten Magneten innerhalb des elektronischen Anbauteils 13 beispielsweise auf einer Nabe des Innenlüfters.

Alternativ kann der Innenlüfter seine Antriebsenergie auch dem Drehfeld der dynamoelektrischen rotatorischen Maschine 2, insbesondere dessen Oberschwingungen entnehmen.

Die elektrische Antriebsenergie des Innenlüfter kann auch direkt den Steller- oder Umrichterkomponenten innerhalb des elektronischen Anbauteils 13 entnommen werden.

Diese Innenlüfter sind dabei bei jeder Ausführungsform innerhalb des stationären Anbauteils 13 drehbar gelagert.

Die Isttemperatur wird dabei jeweils über ein Temperaturmodell und/oder einen oder mehrere Temperatursensoren in der dynamoelektrischen rotatorischen Maschine 2 und/oder dem elektronischen Anbauteil 13 ermittelt.

Durch den Lüfter 15 und den Innenlüfter kann auch zumindest zeitweise auch ein Redundanzbetrieb des Antriebs 1 aufrechterhalten werden, sofern einer der beiden Lüfter ausfallen sollte.

Zur Regelung kann der Antrieb 1 auch eine Regeleinheit aufweisen, die Daten unterschiedlichster Sensoren u.a. Temperatursensoren, Schwingungssensoren, Schallsensoren erhält. Die Temperatursensoren sind bei diesem Antrieb 1 an den relevanten Einbauorten angeordnet. So sind Temperatursensoren für die Außenluft, für das elektronische Anbauteil 13, der Leistungshalbleiter im elektronischen Anbauteil 13, für das oder die Lager 11, 12, für das Wicklungssystem und/oder den Wickelkopf 4, für den Innenraum der Maschine 2, als auch für das Gehäuse 10 und die Umgebung vorgesehen.

Sensoren, die in dem Antrieb 1, also der Maschine 2 und/oder dem elektronischen Anbauteil 13 vorgesehen werden, sind kabelgebunden oder kabellos mit einer Regeleinheit verbunden, die in der elektronischen Anbaueinheit 13 oder am Gehäuse 10 der Maschine 2, insbesondere in einem Klemmenkasten oder in der Maschine 2 angeordnet ist.

Schwingungssensoren sind an der Welle 9, und/oder Lager und/oder Lagerschild und/oder Gehäuse 10 angebracht. Schallsensoren sind vor allem an schallemittierenden Quellen, wie z.B. Rippen oder Lagerschilden 14 vorgesehen. Des Weiteren sind Drehzahlsensoren zur Regelung des Antriebs 1 vorhanden.

Aus all diesen Daten regelt bzw. steuert die Regeleinheit u.a. die Drehzahl des Fremdlüfters oder der Fremdlüfter und/oder die Taktfrequenz des Umrichters. D.h., bei besonders hohen Außentemperaturen und/oder geringer Drehzahl der Welle 9 wird der Fremdlüfter temperaturabhängig zugeschaltet. Dabei ist auch die Drehzahl und damit der Volumenstrom des Fremdlüfters 26 steuer- bzw. regelbar.

Die Isttemperatur vorzugsweise des gesamtem Antriebs 1 wird dabei über einen oder mehrere der oben aufgeführten Temperatursensoren erfasst. Zusätzlich ist es möglich über ein Temperaturmodell die erfassten Werte zu verifizieren bzw. über vorgegebene in der Regeleinheit und/oder einer Cloud (beispielsweise über einen digitalen Zwilling) hinterlegte Algorithmen Temperaturen von Antriebskomponenten zu ermitteln, die nicht direkt mit Sensoren versehen sind.

Damit ist ein energieeffizienter Betrieb des Antriebs 1 durchführbar und Wartungsintervalle des Antriebs 1 und dessen Komponenten sind außerdem besser planbar, wie z.B. Nachschmierfristen der Lager.

Die Sensoren sind dabei Schwingungssensoren, Temperatursensoren, Feuchtigkeitssensoren etc. Vorteilhafterweise übermitteln die Sensoren, ihre Daten leitungsgebunden oder über drahtlose Verbindungen an die Regeleinheit. Die Daten werden entweder durch direkten Kontakt oder optisch (beispielsweise Infrarot-Temperaturmessung) erfasst.

Die Regeleinheiten unterschiedlicher Antriebe 1 können auch über eine Cloud in Kontakt stehen und dabei vorgebbare Daten ihrer Antriebe austauschen.

Damit ergibt sich ein sehr kompakter und leistungsfähiger Antrieb 1, der aufgrund der Regeleinheit einen thermisch und/oder energieeffizienten Betrieb des Antriebs 1 gewährleistet. Dabei greift die Regeleinheit in die Taktfrequenz, den Aussteuergrad und/oder den Steuerwinkel eines Umrichters des elektronischen Anbauteils ein, ebenso wie beispielsweise in die Drehzahl eines Fremdlüfters. Damit ergibt sich im Hinblick auf thermische Grenzen und/oder Energieeffizienz des Antriebs 1 eine optimale und aussteuerbare Verlustaufteilung zwischen den Komponenten der dynamoelektrischen Maschine 2 und den elektronischen Anbauteilen 13.

Mittels der Kühleinheiten, zumindest einer Basiskühleinheit, einer Eigenbelüftung 15 und/oder einer Boosterkühleinheit, die insbesondere die Komponenten der dynamoelektrischen rotatorischen Maschine 2, wie Stator und Rotor, als auch die elektronischen Anbauteile 13, wie Leistungs- und Steuerelektronik, Regeleinheit etc. kühlt, wird somit auch ein thermisch steuer- bzw. regelbarer optimaler Betrieb des Antriebs 1 gewährleistet.

Beispielsweise führen bestimmte Einstellungen der Taktfrequenz des Umrichters zu geringeren Verlusten im Umrichter, aber erhöhen die Verluste in der dynamoelektrischen Maschine 2. Umgekehrt können thermisch günstige Einstellungen für die dynamoelektrische Maschine 2 den Umrichter thermisch stärker belasten. Je nachdem welches dieser Teilsysteme des Antriebs 1 noch thermische Reserven aufweist, kann über die Regeleinheit der Umrichter dementsprechend eingestellt werden. Zusätzlich kann die Regeleinheit auch in die Kühlung eingreifen, indem beispielsweise ein oder mehrere Fremdlüfter des Antriebs 1 zu- oder abgeschaltet werden oder mit dementsprechender Drehzahl betrieben werden.

## Patentansprüche

1. Herstellung eines Umrichters (13) eines Antriebs mit Steller- und/oder Umrichterkomponenten durch folgende Schritte:
- Bereitstellen, einer insbesondere ebenen Anordnung von mehreren Platinen (26, 27) mit jeweils darauf vorgesehenen elektrischen Leiterbahnen, die elektrische Verbindungen aufweisen, wobei eine Zentralplatine (27) eine mittig angeordnete Öffnung (29) aufweist, um einer Welle (9) einen Durchgriff zu gestatten,
- die Platinen (26,27) werden sternförmig angeordnet, indem die Zentralplatine (27) und sie umgebende Randplatinen (26) vorgesehen sind,
- die Randplatinen (26) werden zumindest mit der Zentralplatine (27) über elektrisch leitende Verbindungen verbunden,
- Bestücken der eben ausgelegten Platinen (26, 27) mit den dafür vorgesehenen elektrischen und/oder elektronischen Bauelementen (30),
- elektrische Prüfung der Bestückung, Verdrahtung etc.,
- Anordnen von Segmenten (31) aus thermisch gut leitfähigem Material an wenigstens zwei Platinen, derart, dass durch einen Biegevorgang im Bereich der elektrischen Verbindungen zwischen den Platinen die Segmente eine nahezu umfänglich geschlossene Abdeckung (20) bilden,
- Anordnen von Deckeln (36) an den offenen Seiten der Abdeckung (20), um so eine geschlossene Gehäuseanordnung (38) zu erhalten.

2. Herstellung eines Umrichters (13) eines Antriebs mit Steller- und/oder Umrichterkomponenten nach Anspruch 1, **dadurch gekennzeichnet, dass** die elektrisch leitende Verbindung als eine Starrflexverbindung ausgeführt wird.

3. Herstellung eines Umrichters (13) eines Antriebs mit Steller- und/oder Umrichterkomponenten nach einem der vorhergehenden Ansprüche, **dadurch gekennzeichnet, dass** radiale und/oder axiale Anschlussmöglichkeiten in der Abdeckung (20), insbesondere einem Segment (31) und/oder einem Deckel (36) vorgesehen wird.

4. Herstellung eines Umrichters (13) eines Antriebs mit Steller- und/oder Umrichterkomponenten nach einem der vorhergehenden Ansprüche, **dadurch gekennzeichnet, dass** die Segmente (31) durch Konnektoren miteinander mechanisch verbunden werden.

5. Umrichter (13) eines Antriebs mit Steller- oder Umrichterkomponenten, die auf Platinen (26, 27) angeordnet sind, wobei die Platinen (26, 27) sternförmig angeordnet sind, wobei der Umrichter (13) eine Zentralplatine (27) und diese sie umgebende Randplatinen (26) aufweist, die Randplatinen (26) zumindest mit der der Zentralplatine (27) über elektrisch leitende Verbindungen verbunden sind,
wobei sich eine umfängliche Abdeckung (20) aus mindestens zwei Segmenten (31) zusammensetzt, die aus thermisch gut leitfähigem Material sind,
wobei jedes Segment (31) mit zumindest einer Randplatine (26) in direkt thermisch leitfähigem Kontakt steht,
wobei die Zentralplatine (27) eine mittig angeordnete Öffnung (29) aufweist, um einer Welle (9) einen Durchgriff zu gestatten,
wobei die Randplatinen (26) bzgl. der Zentralplatine (27) an einem Biegeabschnitt (28) im Bereich der elektrischen Verbindungen unter einem vorgegebenen Winkel gebogen angeordnet sind.

6. Umrichter (13) eines Antriebs mit Steller- oder Umrichterkomponenten nach Anspruch 5, **dadurch gekennzeichnet, dass** die elektrisch leitende Verbindung zwischen Randplatine (26) und Zentralplatine (27) eine Starrflexverbindung ist.

7. Umrichter (13) eines Antriebs mit Steller- oder Umrichterkomponenten nach Anspruch 5 oder 6, **dadurch gekennzeichnet, dass**, insbesondere an der radial äußeren Begrenzung der Abdeckung (20) im Wesentlichen axial verlaufende Kühlrippen (21) vorgesehen sind.

8. Antrieb (1) mit
- zumindest einer dynamoelektrischen rotatorischen Maschine (2),
- zumindest einem Umrichter (13) nach einem der Ansprüche 5 bis 7,
- zumindest einer Kühleinheit (15),
- wobei diese Komponenten des Antriebs (1) axial hintereinander angeordnet sind, derart, dass das elektronische Anbauteil (13) axial zwischen dynamoelektrischen rotatorischen Maschine (2) und der Kühleinheit (15) angeordnet ist
- wobei der Umrichter (13), von einem Kühlluftstrom gekühlt ist.

9. Antrieb (1) nach Anspruch 8, **dadurch gekennzeichnet, dass** die Kühlrippen (21) der Abdeckung (20) und Kühlrippen eines Gehäuses (10) der dynamoelektrischen rotatorischen Maschine axial fluchten.

10. Antrieb (1) nach Anspruch 8 oder 9, **dadurch gekennzeichnet, dass** die Kühleinheit (15) als Lüftereinheit ausgebildet ist, die zumindest abschnittsweise über die Abdeckung (20) und die dynamoelektrische rotatorische Maschine (2) einen Kühlluftstrom im Betrieb der dynamoelektrischen rotatorischen Maschine (2) generiert.

11. Antrieb (1) nach Anspruch 10, **dadurch gekennzeichnet, dass** eine Lüfterhaube (16) als Leitvorrichtung des Kühlluftstroms dient, die bis ca. 30% über die axiale Länge des Gehäuses (10) der dynamoelektrischen rotatorischen Maschine (2) ausgehend von der BS-Seite reicht.

12. Antrieb (1) nach einem der vorhergehenden Ansprüche 8 bis 11, **dadurch gekennzeichnet, dass** die Deckel (36) der Abdeckung (20) und das elektronische Anbauteil (13) im Bereich der Welle eine Aussparung aufweisen, um eine Eigenbelüftung des Antriebs (1) zu ermöglichen.

## Claims

1. Production of an inverter (13) of a drive, with actuator and/or inverter components, by means of the following steps:
- providing an in particular planar arrangement of multiple circuit boards (26, 27) with electrical conductor tracks respectively provided thereon, which have electrical connections, wherein a central circuit board (27) has a centrally arranged opening (29) in order to allow the passage of a shaft (9),
- the circuit boards (26, 27) are arranged in a star-shaped manner, in that the central circuit board (27) and peripheral boards (26) surrounding it are provided,
- the peripheral boards (26) are connected at least to the central circuit board (27) via electrically conductive connections,
- populating the circuit boards (26, 27) of planar configuration with the electrical and/or electronic components (30) provided for them,
- electrically testing the populated components and wiring, etc.,
- arranging segments (31) made of a material with high thermal conductivity on at least two circuit boards such that, as a result of a bending process in the region of the electrical connections between the circuit boards, the segments form an approximately peripherally closed cover (20),
- arranging lids (36) on the open sides of the cover (20) in order to thus realize a closed housing arrangement (38).

2. Production of an inverter (13) of a drive with actuator and/or inverter components according to claim 1,
**characterised in that** the electrically conductive connection is designed as a rigid-flex connection.

3. Production of an inverter (13) of a drive with actuator and/or inverter components according to one of the preceding claims, **characterised in that** radial and/or axial connection options are provided in the cover (20), in particular a segment (31) and/or a lid (36).

4. Production of an inverter (13) of a drive with actuator and/or inverter components according to one of the preceding claims, **characterised in that** the segments (31) are mechanically connected to one another by connectors.

5. Inverter (13) of a drive with actuator or inverter components which are arranged on circuit boards (26, 27),
wherein the circuit boards (26, 27) are arranged in a star-shaped manner, wherein the inverter (13) has a central circuit board (27) and peripheral boards (26) surrounding it, the peripheral boards (26) are connected at least to that of the central circuit board (27) via electrically conductive connections,
wherein a peripheral cover (20) is composed of at least two segments (31) which are made of a material with high thermal conductivity,
wherein each segment (31) is in direct thermally conductive contact with at least one peripheral board (26),
wherein the central circuit board (27) has a centrally arranged opening (29) in order to allow the passage of a shaft (9),
wherein the peripheral boards (26) are arranged such that they are bent at a predetermined angle with respect to the central circuit board (27) on a bending section (28) in the region of the electrical connections.

6. Inverter (13) of a drive with actuator or inverter components according to claim 5, **characterised in that** the electrically conductive connection between the peripheral board (26) and the central circuit board (27) is a rigid-flex connection.

7. Inverter (13) of a drive with actuator or inverter components according to claim 5 or 6, **characterised in that** essentially axial cooling fins (21) are provided, in particular on the radially outer boundary of the cover (20).

8. Drive (1) with
- at least one dynamoelectric rotary machine (2),
- at least one inverter (13) according to one of claims 5 to 7,
- at least one cooling unit (15),
- wherein these components of the drive (1) are arranged axially one behind the other such that the electronic add-on part (13) is arranged axially between the dynamoelectric rotary machine (2) and the cooling unit (15)
- wherein the inverter (13) is cooled by a cooling air flow.

9. Drive (1) according to claim 8, **characterised in that** the cooling fins (21) of the cover (20) and cooling fins of a housing (10) of the dynamoelectric rotary machine are axially aligned.

10. Drive (1) according to claim 8 or 9,
**characterised in that** the cooling unit (15) is designed as a fan unit which generates a cooling air flow at least in sections via the cover (20) and the dynamoelectric rotary machine (2) during operation of the dynamoelectric rotary machine (2).

11. Drive (1) according to claim 10, **characterised in that** a fan cowl (16) serves as a guide device for the cooling air flow, which extends up to approx. 30% over the axial length of the housing (10) of the dynamoelectric rotary machine (2) starting from the BS side.

12. Drive (1) according to one of the preceding claims 8 to 11, **characterised in that** the lid (36) of the cover (20) and the electronic add-on part (13) have a recess in the region of the shaft to enable self-ventilation of the drive (1).

## Revendications

1. Fabrication d'un convertisseur (13) d'un entraînement ayant des composants d'actionneur et/ou de convertisseur par les stades suivants :
- on se procure un agencement, en particulier plan, de plusieurs platines (26, 27), sur chacune desquelles sont prévues des pistes conductrices de l'électricité, qui ont des connexions électriques, une piste (27) centrale ayant une ouverture (29) disposée au milieu afin d'autoriser le passage d'un arbre (9),
- on dispose les platines (26, 27) en étoile, en prévoyant la platine (27) centrale et les platines (26) marginales qui l'entourent,
- on connecte les platines (26) marginales au moins à la platine (27) centrale par des connexions conductrices de l'électricité,
- on équipe les platines (26, 27) de conception plane des composants (30) électriques et/ou électroniques prévus à cet effet,
- on contrôle électriquement l'équipement, le câblage, etc.,
- on met des segments (31) en matériau bon conducteur de la chaleur sur au moins deux platines de manière à ce que, par une opération de flexion dans la partie d'une connexion électrique entre les platines, les segments forment un recouvrement (20) fermé à peu près périphérique,
- on met des couvercles (36) sur les côtés ouverts du recouvrement (20), pour obtenir ainsi un agencement (38) de boîtier fermé.

2. Fabrication d'un convertisseur (13) d'un entraînement ayant des composants d'actionneur et/ou de convertisseur suivant la revendication 1, **caractérisée en ce que** l'on réalise la connexion conductrice de l'électricité sous la forme d'une connexion starflex.

3. Fabrication d'un convertisseur (13) d'un entraînement ayant des composants d'actionneur et/ou de convertisseur suivant l'une des revendications précédentes, **caractérisée en ce que** l'on prévoit des possibilités de connexion radiales et/ou axiales dans le recouvrement (20), en particulier dans un segment (31) et/ou un couvercle (36).

4. Fabrication d'un convertisseur (13) d'un entraînement ayant des composants d'actionneur et/ou de convertisseur suivant l'une des revendications précédentes, **caractérisée en ce que** l'on assemble mécaniquement les uns aux autres les segments (31) par des connecteurs.

5. Convertisseur (13) d'un entraînement ayant des composants d'actionneur ou de convertisseur qui sont disposés sur des platines (26, 27), dans lequel les platines (26, 27) sont disposées en étoile, dans lequel le convertisseur (13) a une platine (27) centrale et des platines (26) marginales entourant celles-ci, les platines (26) marginales étant connectées au moins à la platine (27) centrale par des connexions conductrices de l'électricité,
dans lequel un recouvrement (20) périphérique est composé d'au moins deux segments (31) qui sont en un matériau bon conducteur de la chaleur,
dans lequel chaque segment (31) est en contact conducteur directement de la chaleur avec au moins une platine (26) marginale,
dans lequel la platine (27) centrale a une ouverture (29) au milieu, afin de permettre le passage d'un arbre (9),
dans lequel les platines (26) marginales et respectivement la platine (27) centrale sont disposées sur une partie (28) de flexion dans la partie des connexions électriques en étant incurvées suivant un angle donné à l'avance.

6. Convertisseur (13) d'un entraînement ayant des composants d'actionneur ou de convertisseur suivant la revendication 5, **caractérisé en ce que** la connexion conductrice de l'électricité entre la platine (26) marginale et la platine (27) centrale est une connexion starflex.

7. Convertisseur (13) d'un entraînement ayant des composants d'actionneur ou de convertisseur suivant la revendication 5 ou 6, **caractérisé en ce qu'**il est prévu, en particulier sur la délimitation extérieure radialement du recouvrement (20), des nervures (21) de refroidissement s'étendant sensiblement axialement.

8. Entraînement (1) comprenant
- au moins une machine (2) tournante dynamoélectrique,
- au moins un convertisseur (13) suivant l'une des revendications 5 à 7,
- au moins une unité (15) de refroidissement,
- dans lequel ces composants de l'entraînement (1) sont disposés les uns derrière les autres axialement, de manière à ce que la partie (13) électronique rapportée soit disposée axialement entre la machine (2) tournante dynamoélectrique et l'unité (15) de refroidissement,
- dans lequel le convertisseur (13) est refroidi par un courant d'air de refroidissement.

9. Entraînement (1) suivant la revendication 8, **caractérisé en ce que** les nervures (21) de refroidissement du recouvrement (20) et des nervures de refroidissement d'une carcasse (10) de la machine tournante dynamoélectrique sont alignées axialement.

10. Entraînement (1) suivant la revendication 8 ou 9, **caractérisé en ce que** l'unité (15) de refroidissement est constituée sous la forme d'une unité de ventilateur, qui produit au moins par endroit, sur le recouvrement (20) et sur la machine (2) tournante dynamoélectrique, un courant d'air de refroidissement, alors que la machine (2) tournante dynamoélectrique est en fonctionnement.

11. Entraînement (1) suivant la revendication 10, **caractérisé en ce qu'**une hotte (16) de ventilateur sert de dispositif de conduite du courant d'air de refroidissement, qui, à partir du côté BS, va jusqu'à environ 30% de la longueur axiale de la carcasse (10) de la machine (2) tournante dynamoélectrique.

12. Entraînement (1) suivant l'une des revendications 8 à 11, **caractérisé en ce que** les couvercles (36) du recouvrement (20) et la partie (13) électronique rapportée ont, dans la partie de l'arbre, un évidement pour rendre possible une ventilation propre de l'entraînement (1).
